# EUROPEAN PATENT APPLICATION

(11) **EP 1 659 687 A1**
(43) Date of publication of application: **24.05.2006**
(21) Application number: 05025250.1
(22) Date of filing: 18.11.2005
(51) Int. Cl.: H03H 9/02

(54) **Surface acoustic wave device and electronic apparatus**

(30) Priority: 22.11.2004 JP 2004336996
(71) Applicant: SEIKO EPSON CORPORATION, Shinjuku-ku, Tokyo 163-0811 (JP)
(72) Inventor: Kanna, Shigeo, Suwa-shi Nagano-ken 392-8502 (JP)
(74) Representative: HOFFMANN EITLE

(57) **Abstract**

A surface acoustic wave device (10) including at least an interdigital transducer electrode (12;21,22) that excites a Rayleigh surface acoustic wave on a surface of a crystal substrate (11) and giving excitation in an upper limit mode of a stopband of the surface acoustic wave, wherein Euler angle representation (Φ,θ,ψ) showing a cut angle and surface acoustic wave propagation direction of the crystal substrate is set as (0°,0° ≤ θ ≤ 180°,0° < |ψ| < 90°), preferably (0°,95° ≤ θ ≤ 155°,33° < |ψ| < 46°) or (0°,123°,41°).

## Description

### BACKGROUND

### 1. Technical Field

The present invention relates to a surface acoustic wave (SAW) device using an upper limit mode of the stopband of Rayleigh surface acoustic waves.

### 2. Related Art

SAW devices, represented by SAW resonators and SAW filters, are widely used in the field of communications for their advantageous features in high-frequency and compact applications and in mass production. In particular, SAW devices using quartz substrates, represented by ST-cut quartz substrates, provide high accuracy with the high temperature stability of quartz. Further accurate SAW devices with higher stability for high-frequency and compact applications and for temperature changes have been required in recent years with the advance of mobile communications equipment, for example.

Achieving SAW devices that can provide high-frequency applications and offer temperature stability involves conflicting factors to be resolved. Various efforts have been made to address this issue. An oscillation frequency of a SAW device using an ST-cut quartz substrate is determined by the pitch of an interdigital transducer (IDT) electrode. Therefore, it is necessary to lower the pitch of the IDT electrode to make the oscillation frequency high. For this purpose, the width and thickness of the IDT electrode are designed to be small in proportion to the pitch. As a result, the resistance of the IDT electrode rises, and thereby the impedance of the SAW device increases.

In order to overcome this issue, the thickness of the IDT electrode may be increased. However, a thicker IDT electrode is known to significantly lower the oscillation frequency. To achieve both a thicker IDT electrode and a higher oscillation frequency, it is necessary to make the IDT electrode microscopic by further reducing its width, which may in turn lower manufacturing yields. Furthermore, as described in *Technical Report of IEICE*, the Institute of Electronics, Information and Communication Engineers, US99-20 (1999-06): pp. 37-42 (Fig. 4), the thicker the IDT electrode is, the larger the absolute value of a second temperature coefficient in a frequency temperature characteristic (i.e. frequency variation characteristic with temperature) becomes. In other words, frequency variation with temperature changes increases, and thereby harming the temperature stability of the quartz substrate.

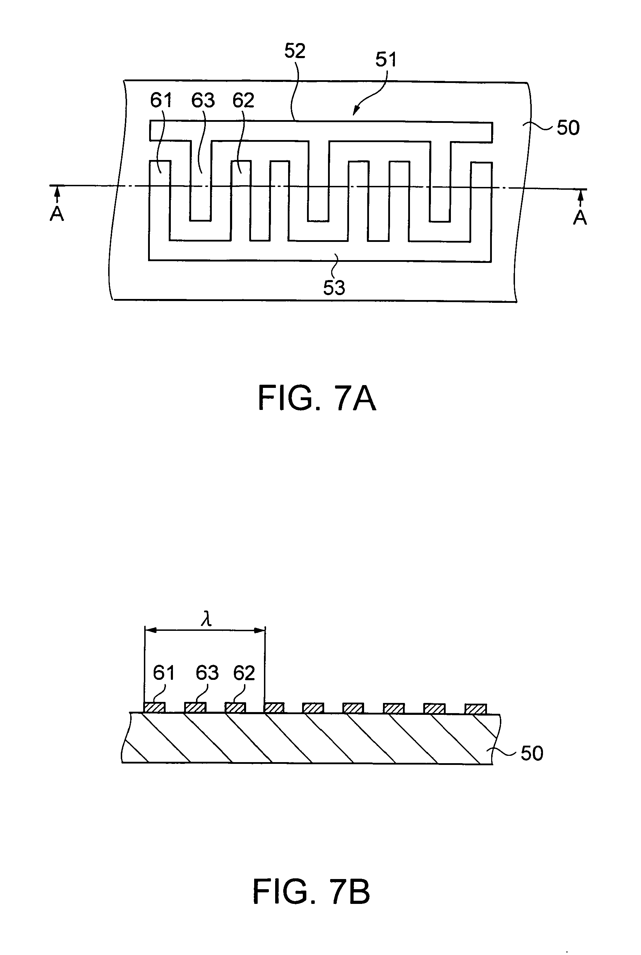

Rayleigh surface acoustic waves excited by an IDT electrode provided to a piezoelectric substrate made of quartz, for example, are known to provide two frequency solutions called the stopband. Either of these two frequency solutions, a lower frequency (lower limit mode) and a higher frequency (upper limit mode), is used for excitation. When an ST-cut quartz substrate is provided with a single IDT electrode having two electrode fingers in one SAW wavelength, surface acoustic waves are excited in the lower limit mode of the stopband. As also described in the above-mentioned *Technical Report of IEICE,* the upper limit mode provides a smaller absolute value of the second temperature coefficient in the frequency temperature characteristic and a smaller change (increase or decrease) in the absolute value of the second temperature coefficient when increasing the thickness of the IDT electrode than the lower limit mode does. Accordingly, the upper limit mode provides a better frequency temperature characteristic and is more suitable for high-frequency applications. However, the single IDT electrode provided to the ST-cut quartz substrate is not capable of exciting surface acoustic waves in the upper limit mode. Therefore, JP-A-2002-100959 (Fig. 13) proposes a SAW device having a reflecting/inverting IDT electrode as a means for excitation in the upper limit mode of the stopband. As shown in Fig. 7, this reflecting/inverting IDT electrode 51 includes electrodes 52, 53 having electrode fingers and interdigitated with each other on a piezoelectric substrate 50. This structure includes three electrode fingers 61, 62, 63 in one SAW wavelength λ. The electrode fingers 61, 62 and the electrode finger 63 are driven in opposite phases to each other.

Since the reflecting/inverting IDT electrode has three electrode fingers in one wavelength, the width of the IDT electrode has to be further reduced to provide a high-frequency application in comparison with a generally used, single IDT electrode having two electrode fingers in one SAW wavelength. Accordingly, the reflecting/inverting IDT electrode is not suitable for high-frequency applications, and its mass production may involve reduced yields.

### SUMMARY

An advantage of the invention is to provide a SAW device that has a good frequency temperature characteristic and easily provides a high-frequency application by using the upper limit mode of the stopband as the oscillation frequency of the SAW device.

In a SAW device according to an aspect of the invention including at least an IDT electrode that excites a Rayleigh surface acoustic wave on a surface of a crystal substrate and giving excitation in the upper limit mode of a stopband of the surface acoustic wave, Euler angle representation (Φ, θ, ψ) showing a cut angle and SAW propagation direction of the crystal substrate is set as (0°, 0° ≤ θ ≤ 180°, 0° < |ψ| < 90°).

This structure can make the SAW propagation direction shift to a position remote from a quartz symmetry position in the quartz substrate, and can use the upper limit mode of the stopband as an oscillation frequency of surface acoustic waves. This structure thus facilitates a reduction in the size of the IDT electrode and easily provides high-frequency applications of the SAW device compared with using the lower limit mode of the stopband.

In the SAW device according to the invention, the IDT electrode may be a single IDT electrode.

This structure can use the upper limit mode without using a reflecting/inverting IDT electrode as the IDT electrode. Since it is sufficient to provide two electrode fingers with the single IDT electrode in one SAW wavelength, lowering of manufacturing yields can be reduced and high-frequency applications can be easily provided compared with using the reflecting/inverting IDT electrode, which requires three electrode fingers in one SAW wavelength.

In the SAW device according to the invention, Euler angle representation (Φ, θ, ψ) showing a cut angle and SAW propagation direction of the crystal substrate may be set as (0°, 0° ≤ θ ≤ 180°, 9° ≤ |ψ| ≤ 46°).

This structure can provide a SAW device whose frequency variation with temperature is smaller than when using an ST-cut quartz substrate.

In the SAW device according to the invention, Euler angle representation (Φ, θ, ψ) showing a cut angle and SAW propagation direction of the crystal substrate may be set as (0°, 95° ≤ θ ≤ 155°, 33° ≤ |ψ| ≤ 46°).

This structure can provide a SAW device whose frequency variation with temperature is smaller than when using an in-plane rotation ST-cut quartz substrate.

An electronic apparatus according to another aspect of the invention includes the above-described SAW device.

Having the SAW device that provides a high-frequency application and has a good frequency temperature characteristic, this structure provides an electronic apparatus that has a good characteristic.

### BRIEF DESCRIPTION OF THE DRAWINGS

The invention will be described with reference to the accompanying drawings, wherein like numbers reference like elements.

Fig. 1 is a diagram for describing an Euler angle.

Fig. 2 is a graph showing frequency changes in the upper and lower limit mode while changing the thickness of an IDT electrode with an ST-cut quartz substrate.

Fig. 3 is a schematic of a SAW resonator according to one embodiment. Fig. 3A is a schematic plan view showing the SAW resonator, while Fig. 3B is a schematic sectional view along line A-A of Fig. 3A.

Fig. 4 is a graph showing the frequency variation and substrate cut angle measures θ and ψ of the SAW resonator according to the present embodiment.

Fig. 5 is a partial sectional view showing a SAW resonator that is packaged.

Fig. 6 shows a structure of an electronic apparatus.

Fig. 7 is a schematic of a related art reflecting/inverting IDT electrode. Fig. 7A is a schematic plan view, while Fig. 7B is a schematic sectional view along line A-A of Fig. 7A.

### DESCRIPTION OF THE EMBODIMENTS

Embodiments of the present invention will be described with reference to the accompanying drawings. First, Euler angle representation (Φ, θ, ψ) will be described to specify a cut angle and a SAW propagation direction of a quartz substrate.

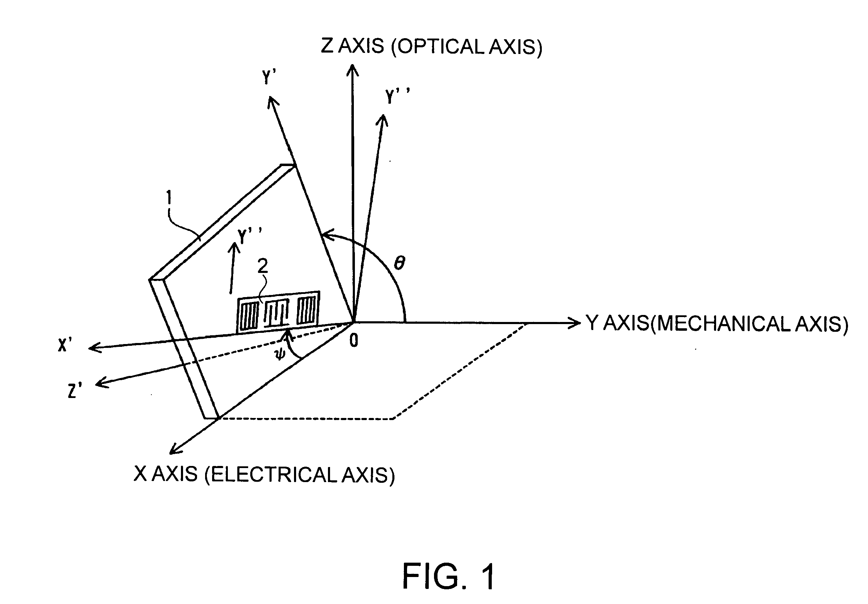

Fig. 1 is a diagram for describing an Euler angle. The crystal axis of quartz is defined by an X axis (electrical axis), a Y axis (mechanical axis) and a Z axis (optical axis). A crystal plate whose Euler angle representation is (0°, 0°, 0°) is perpendicular to the Z axis. An angle Φ for rotating the X axis and the Y axis with the Z axis as a rotation axis is herein fixed at 0 degrees.

The coordinate axes obtained by rotating the Y and Z axes counterclockwise by θ degrees with the X axis as a rotation axis are referred to as Y' and Z' axes, respectively. This Z' axis serves as a normal line for cutting out a quartz substrate 1 with surface orientation including the X and Y' axes. The coordinate axes obtained by rotating the X and Y' axes of this quartz substrate 1 cut out with the surface orientation by ψ degrees with the Z' axis as a rotation axis are referred to as X' and Y" axes, respectively. The X' axis is set as the SAW propagation direction of a SAW device 2. The angle ψ of the quartz substrate 1 is called an in-plane rotation angle. The cut angle and the SAW propagation direction of the quartz substrate can be thus specified by the Euler angle representation (Φ, θ, ψ).

Advantages of using the upper limit mode of the stopband of surface acoustic waves will now be described. As described above, the upper limit mode of the stopband of surface acoustic waves provides a smaller absolute value of the second temperature coefficient in the frequency temperature characteristic and a smaller change in the absolute value of the second temperature coefficient when increasing the thickness of the IDT electrode than the lower limit mode does. In addition, the inventors have found that the upper limit mode causes a smaller change in oscillation frequencies when increasing the thickness of the IDT electrode than the lower limit mode does.

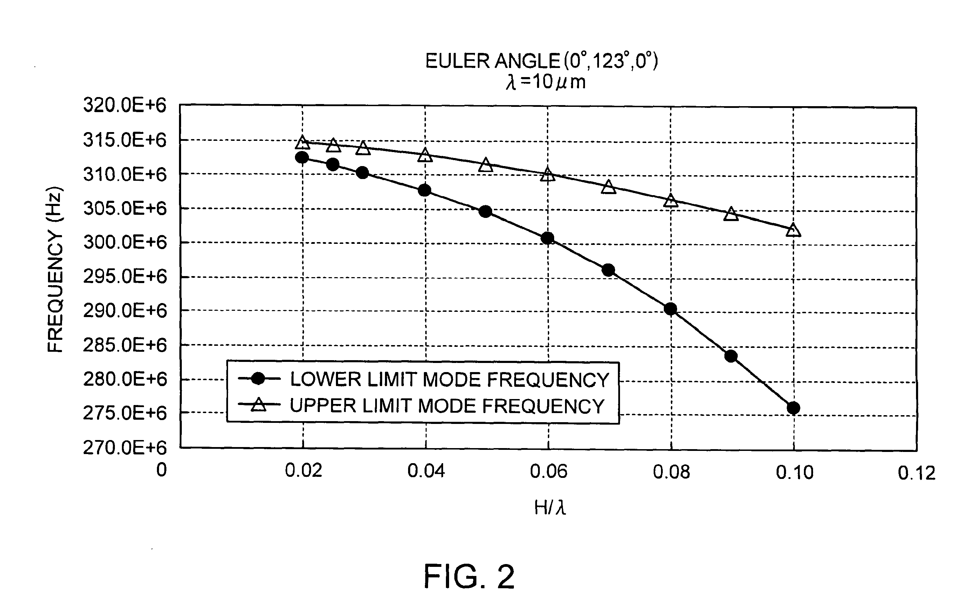

Fig. 2 shows frequency changes in the upper and lower limit modes while changing the thickness of the IDT electrode with an ST-cut quartz substrate. In Fig. 2, the vertical axis represents frequency. The horizontal axis represents standardized electrode thickness H/λ, which is obtained by dividing the thickness H of the IDT electrode by wavelength λ (10 µm, here). The frequencies in the upper and lower limit modes are frequencies under a short-circuit condition in the respective modes. Frequencies in both the upper and lower limit modes tend to lower as the thickness H of the IDT electrode increases. The upper limit mode causes a smaller reduction in frequencies when increasing the thickness H of the IDT electrode than the lower limit mode does.

Therefore, using the upper limit mode of the stopband of surface acoustic waves is effective in improving the frequency temperature characteristic and causing a small reduction in frequencies when increasing the thickness of the IDT electrode to improve the resistance (impedance) of the IDT electrode. The frequency reductions shown in Fig. 2 are the result obtained when using Al as an IDT electrode material. For example, using Au whose specific gravity is higher than that of Al as an IDT electrode material involves a larger frequency reduction in the lower and upper limit modes. A1 and other low-specific-gravity materials are more effective in forming the IDT electrode to provide high-frequency applications.

### First Embodiment

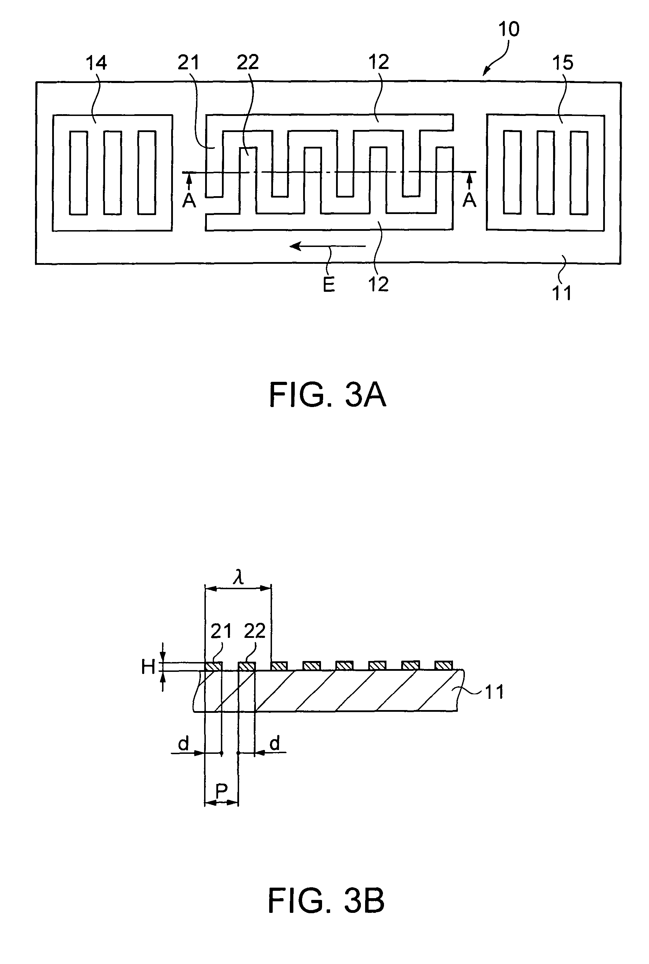

One embodiment of the invention will now be described by taking a SAW resonator as an example of a SAW device. Fig. 3 is a schematic of this SAW resonator as a SAW device having a single IDT electrode. Fig. 3A is a schematic plan view showing the SAW resonator. Fig. 3B is a schematic sectional view along line A-A of Fig. 3A.

This SAW resonator 10 includes IDT electrodes 12 having electrode fingers 21, 22 on the surface of a quartz substrate 11, and reflectors 14, 15 provided on both sides thereof. The IDT electrodes 12 are arranged such that the electrode fingers 21, 22 are interdigitated with each other. The electrode fingers 21, 22 have a thickness H and a width d. A pitch P between the electrode fingers 21, 22 is fixed, and the space of the pitch is provided continuously. This structure includes two electrode fingers 21, 22 in one SAW wavelength λ. An IDT electrode having this structure of the IDT electrodes 12 is generally called a single IDT electrode. The IDT electrodes 12 are made of Al and driven in opposite phases to each other. The quartz substrate 11 is cut out from quartz so as to be within an Euler angle range of (0°, 0° ≤ θ ≤ 180°, 0° < |ψ| < 90°). The direction indicated by the arrow E corresponds to the X' axis, i.e. the SAW propagation direction described in Fig. 1.

The SAW resonator 10 of this structure reflects surface acoustic waves excited by the IDT electrodes 12 and propagating outward with the reflectors 14, 15, and confines SAW energy in the portions of the IDT electrodes 12 and the reflectors 14, 15, thereby gaining a resonance characteristic with a small loss.

A related art ST-cut quartz substrate has an Euler angle representation of (0°, 123°, 0°), for example. If a SAW resonator has a single IDT electrode provided to this substrate, surface acoustic waves are excited in the lower limit mode of the stopband. Whether excitation is given in the upper or lower limit mode of the stopband depends on a frequency gap between short-circuit and open conditions for each mode's frequency. If there is a frequency gap, waves are exited in the mode.

Table 1 shows a frequency gap between short-circuit and open conditions in the upper limit mode with an ST-cut quartz substrate another quartz substrate having a cut angle according to the embodiment of the invention both of which are provided with a single IDT electrode. Referring to Table 1, a SAW wavelength λ is fixed at 10 µm and the following conditions are variables: standardized electrode width (d/P), which is obtained by dividing the width d of the electrode fingers by the pith P thereof, and standardized electrode thickness (H/λ), which is obtained by dividing the thickness H of the electrode fingers by the wavelength λ.
Also, the table shows an absolute difference between one frequency fᵤₛ under the short-circuit condition in the upper limit mode and another frequency fᵤₒ under the open condition in the upper limit mode.

**Table 1**

| Condition | | \|fᵤₛ-fᵤₒ\| (MHz) (λ = 10 µm) |
|---|---|---|
| A | (0°, 123°, 0°) | 0 |
| | d/P = 0.5, H/λ = 0.03 | |
| B | (0°, 123°, 0°) | 0 |
| | d/P = 0.7, H/λ = 0.10 | |
| C | (0°, 123°, 41°) | 0.0015 |
| | d/P = 0.5, H/λ = 0.03 | |
| D | (0°, 123°, 41°) | 0.1667 |
| | d/P = 0.7, H/λ = 0.10 | |

Referring to Table 1, Condition A uses the ST-cut quartz substrate, and d/P is 0.5 while H/λ is 0.03. A frequency gap between the short-circuit and open conditions in the upper limit mode is zero. Condition B also uses the ST-cut quartz substrate, and d/P is 0.7 while H/λ is 0.10. A frequency gap between the short-circuit and open conditions in the upper limit mode is zero. Accordingly, when using the ST-cut quartz substrate, surface acoustic waves cannot be excited in the upper limit mode of the stopband with any size of the electrode fingers included in the IDT electrode.

The case of a quartz substrate having an Euler angle representation of (0°, 123°, 41°) that is an example of a cut angle according to the embodiment of the invention will now be described. Condition C uses the quartz substrate having a cut angle according to the embodiment of the invention, and d/P is 0.5 while H/λ is 0.03. A frequency gap between the short-circuit and open conditions in the upper limit mode is 0.0015 MHz. Condition D also uses the quartz substrate having a cut angle according to the embodiment of the invention, and d/P is 0.7 while H/λ is 0.10. A frequency gap between the short-circuit and open conditions in the upper limit mode is 0.1667 MHz. Accordingly, when using the quartz substrate according to the embodiment of the invention, surface acoustic waves can be excited in the upper limit mode of the stopband. This means that if a cut angle is arranged so as to change from symmetry to asymmetry in quartz crystal, surface acoustic waves in the upper limit mode can be excited.

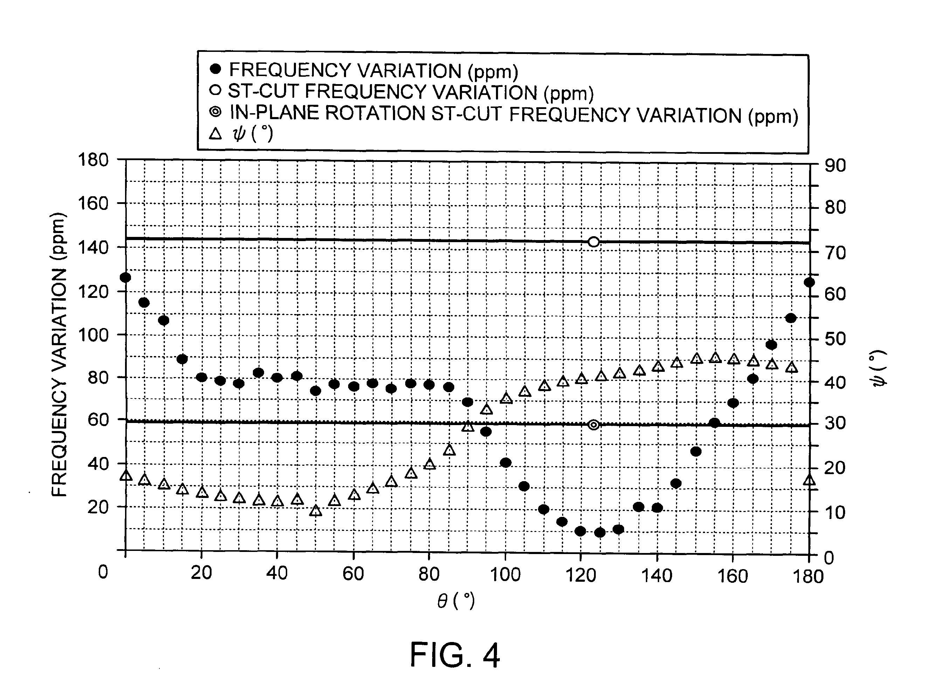

Frequency variation with temperature with a quartz substrate having a cut angle according to the present embodiment using the upper limit mode of the stopband will now be described. Fig. 4 is a graph showing the frequency variation with temperature of the SAW resonator according to the present embodiment. The frequency variation is calculated by subtracting a minimum frequency deviation from a maximum frequency deviation. The frequency deviation is calculated as follows: (Frequency at a given temperature - Frequency at 25 degrees Celsius) / Frequency at 25 degrees Celsius. The conditions used here are as follows: temperature ranges from -40 to 90 degrees Celsius, the single IDT electrode's standardized electrode width d/P is 0.7 and standardized electrode thickness H/λ is 0.10. The cut angle Φ of the quartz substrate is fixed at 0°. The dots show the optimum (minimum) frequency variation when changing an in-plane rotation angle ψ within the range from 0° to 90° with θ ranging from 0° to 180°. The triangles show the in-plane rotation angle ψ at each point. For example, when Φ is fixed at 0° and θ at 40°, and the in-plane rotation angle ψ ranges from 0° to 90°, the minimum frequency variation is about 80 ppm. The in-plane rotation angle ψ at this point is about 12°. Note that both positive and negative angles are applicable to the angle ψ for the symmetry property of quartz crystal, and the both produce the same results. Moreover, instead of the Euler angle representation, a quartz substrate with a cut angle that is crystallographically equivalent to the representation can be used.

As mentioned above, the quartz substrate whose cut angle and SAW propagation direction are within the range of (0°, 0° ≤ θ ≤ 180°, 0° < |ψ| < 90°) can make the SAW propagation direction shift to a position remote from a quartz symmetry position in the quartz substrate. Therefore, it is possible to excite surface acoustic waves in the upper limit mode of the stopband with the single IDT electrode. Consequently, a better frequency temperature characteristic can be provided than when using the lower limit mode of the stopband. Furthermore, it is possible to facilitate a reduction in the size of the IDT electrode, and thereby high-frequency applications of the SAW device can be easily provided. Also, since the single IDT electrode is applicable, it is possible to reduce lowering of manufacturing yields, and thereby high-frequency applications can be further easily provided compared with using the reflecting/inverting IDT electrode.

### Second Embodiment

The cut angle and SAW propagation direction of the quartz substrate 11 provided with the SAW resonator shown in Fig. 3 can also be set within an Euler angle range of (0°, 0° ≤ θ ≤ 180°, 9° ≤ |ψ| ≤ 46°). As shown in Fig. 4, if the temperature ranges from -40 to 90 degrees Celsius, the frequency variation is about 127 ppm at the maximum. The second temperature coefficient of an ST-cut quartz substrate is generally represented by the formula: -3.4 * 10⁻⁸ {1/(degrees C)²}. If the temperature ranges from -40 to 90 degrees Celsius, the frequency variation is about 144 ppm.

Consequently, by setting the cut angle and SAW propagation direction of the quartz substrate 11 in the SAW device within the Euler angle range of (0°, 0° ≤ θ ≤ 180°, 9° ≤ |ψ| ≤ 46°), the frequency variation can be lowered compared with using the ST-cut quartz substrate.

### Third Embodiment

The cut angle and SAW propagation direction of the quartz substrate 11 provided with the SAW resonator shown in Fig. 3 can also be set within the Euler angle range of (0°, 95° ≤ θ ≤ 155°, 33° ≤ |ψ| ≤ 46°). As shown in Fig. 4, if the temperature ranges from -40° to 90°, the frequency variation is about 59 ppm at the maximum. According to *Temperature Stability of Surface Acoustic Wave Resonators on In-Plane Rotated 33° Y-Cut Quartz* (JJAP, Vol. 42 (2003), pp. 3136-3138), the second temperature coefficient with an Euler angle representation of (0°, 123°, 43.4°) in the lower limit mode of the stopband is represented by the formula: -1.4 * 10⁻⁸ {1/(degrees C)²}. If the temperature ranges from -40 to 90 degrees Celsius, the frequency variation is about 59 ppm.

Consequently, by setting the cut angle and SAW propagation direction of the quartz substrate 11 provided with the SAW resonator within the Euler angle range of (0°, 95° ≤ 0 ≤ 155°, 33° ≤ |ψ| ≤ 46°), the frequency variation can be lowered compared with using the in-plane rotation ST-cut quartz substrate.

### Fourth Embodiment

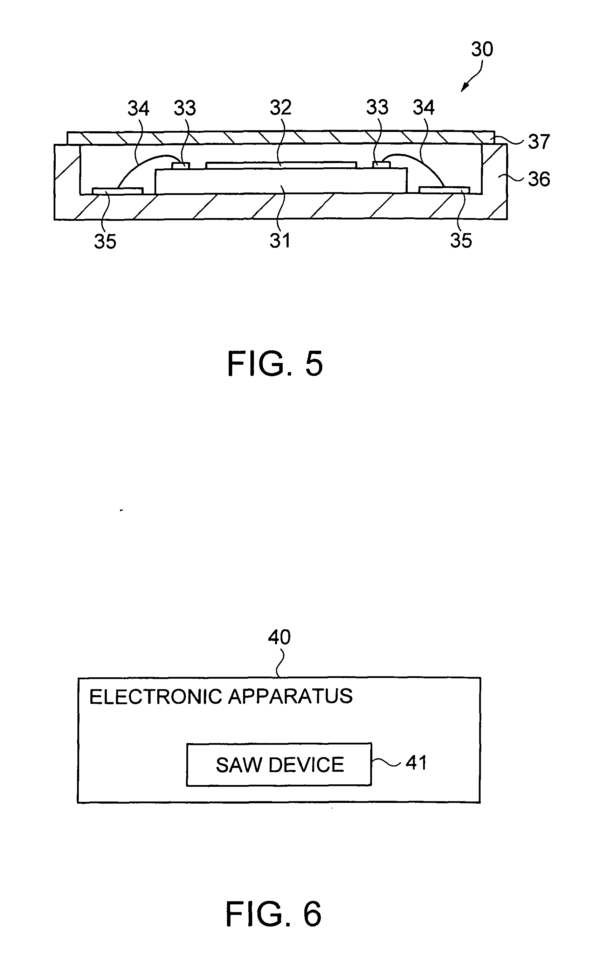

Fig. 5 is a partial sectional view showing another embodiment in which a SAW resonator as a SAW device according to the embodiment of the invention is packaged. In a container 36 made of ceramic, for example, a SAW resonator 31 that is shown in the above-described embodiments is fixed and housed. Provided on the surface of the SAW resonator 31 are an IDT electrode 32 and a coupling pad 33 to be coupled to the IDT electrode. The coupling pad 33 of the SAW resonator 31 is electrically coupled to a coupling terminal 35 provided to the container 36 via a wire 34 made of Au, for example. A lid 37 is used for sealing so as to maintain a vacuum or inert gas atmosphere inside the container 36, which completes a packaged SAW resonator 30.

In the SAW resonator according to the present embodiment, the IDT electrode 32 is thin to provide a high-frequency application. Since the thickness of the IDT electrode can be increased without greatly changing the frequency variation or the second temperature coefficient of the frequency temperature characteristic as mentioned above, it is possible to provide the thickness that is applicable to wire bonding. This way reliability for electrical coupling can be increased. It is thus possible to provide the packaged SAW resonator 30 that uses the upper limit mode of the stopband, has a good frequency temperature characteristic and easily provides a high-frequency application.

### Fifth Embodiment

Fig. 6 shows a structure of an electronic apparatus according to a yet another embodiment of the invention. This electronic apparatus 40, e.g. a cellular phone or a navigation system, is provided with a SAW resonator that is a high-frequency application as a SAW device 41 according to the embodiment of the invention. Since the SAW resonator has a good frequency temperature characteristic and provides a high-frequency application, it is possible to provide this electronic apparatus having a good characteristic.

While examples of the SAW resonator as a SAW device have been given, a SAW filter can also be provided in the same manner. This is because, in a resonator-type SAW filter, the SAW filter is constructed by using resonance at a stopband end. The SAW filter thus has a good frequency temperature characteristic and easily provides a high-frequency application by using the upper limit mode of the stopband.

## Claims

1. A surface acoustic wave device including at least an interdigital transducer electrode that excites a Rayleigh surface acoustic wave on a surface of a crystal substrate and giving excitation in an upper limit mode of a stopband of the surface acoustic wave,
wherein Euler angle representation (Φ, θ, ψ) showing a cut angle and surface acoustic wave propagation direction of the crystal substrate is set as (0°, 0° ≤ θ ≤ 180°, 0° < |ψ| < 90°).

2. The surface acoustic wave device according to Claim 1, wherein the interdigital transducer electrode is a single interdigital transducer electrode.

3. The surface acoustic wave device according to Claim 1, wherein Euler angle representation (Φ, θ, ψ) showing a cut angle and surface acoustic wave propagation direction of the crystal substrate is set as (0°, 0° ≤ θ ≤ 180°, 9° ≤ |ψ| ≤ 46°).

4. The surface acoustic wave device according to Claim 1, wherein Euler angle representation (Φ, θ, ψ) showing a cut angle and surface acoustic wave propagation direction of the crystal substrate is set as (0°, 95° ≤ θ ≤ 155°, 33° ≤ |ψ| ≤ 46°).

5. An electronic apparatus, comprising:
the surface acoustic wave device according to Claim 1.
